# EUROPÄISCHE PATENTSCHRIFT

(11) **EP 1 321 966 B1**
(45) Veröffentlichungstag und Bekanntmachung des Hinweises auf die Patenterteilung: **11.04.2007**
(21) Anmeldenummer: 01130532.3
(22) Anmeldetag: 21.12.2001
(51) Int. Cl.: H01L 21/00

(54) **Greifwerkzeug zum Montieren von Halbleiterchips**
Gripping tool for mounting semiconductor chips
Outil de préhension pour le montage de puces semiconductrices

(43) Veröffentlichungstag der Anmeldung: 25.06.2003
(73) Patentinhaber: Unaxis International Trading Ltd, 6330 Cham (CH)
(72) Erfinder: Schnetzler, Daniel, 6314 Unterägeri (CH); Huwyler, Rolf, 5620 Bremgarten (CH); Heggli, Guido, 6330 Cham (CH)
(74) Vertreter: Falk, Urs

(56) Entgegenhaltungen:
- PATENT ABSTRACTS OF JAPAN vol. 1995, no. 06, 31. Juli 1995 (1995-07-31) -& JP 07 066092 A (SUMITOMO SITIX CORP), 10. März 1995 (1995-03-10)
- PATENT ABSTRACTS OF JAPAN vol. 1999, no. 02, 26. Februar 1999 (1999-02-26) -& JP 10 313042 A (SONY CORP), 24. November 1998 (1998-11-24)
- PATENT ABSTRACTS OF JAPAN vol. 018, no. 372 (E-1577), 13. Juli 1994 (1994-07-13) -& JP 06 104300 A (FUJITSU LTD;OTHERS: 01), 15. April 1994 (1994-04-15)
- PATENT ABSTRACTS OF JAPAN vol. 2000, no. 20, 10. Juli 2001 (2001-07-10) -& JP 2001 077295 A (SONY CORP), 23. März 2001 (2001-03-23)

## Beschreibung

Die Erfindung betrifft ein Greifwerkzeug zum Montieren von Halbleiterchips. Solche Greifwerkzeuge sind bekannt unter den Fachbegriffen "die collet" oder "die bonding tool".

Bei der Montage von Halbleiterchips werden die aus einem Wafer gesägten und auf einer Folie haftenden Halbleiterchips vom Greifwerkzeug ergriffen und auf einem Substrat plaziert. Ein solches Greifwerkzeug besteht im wesentlichen aus einem Metallschaft und einem daran befestigten Saugorgan. Das Saugorgan weist einen gegen den zu ergreifenden Halbleiterchip gerichteten, über eine Bohrung mit Vakuum beaufschlagbaren Hohlraum auf. Sobald das Saugorgan auf dem Halbleiterchip aufliegt, bewirkt das Vakuum die Haftung des Halbleiterchips am Saugorgan. In der Fachwelt wird das Saugorgan als Pick-up Tool oder als Rubbertip bezeichnet.

Halbleiterchips werden auch übereinander montiert, in der Fachwelt sind die übereinander montierten Halbleiterchips als "stacked dies" bekannt. Dabei wird zunächst ein erster Halbleiterchip auf einem Substrat montiert, in der Regel auf herkömmliche Art mittels einer Portion Klebstoff aus Epoxy. Die Befestigung eines zweiten Halbleiterchips auf dem ersten Halbleiterchip erfolgt mittels eines auf der Rückseite des zweiten Halbleiterchips aufgebrachten Klebstofffilms. Dabei wird die Rückseite eines Wafers mit den zweiten Halbleiterchips mit dem Klebstoff beschichtet, der Wafer dann auf eine Folie aufgeklebt und in die einzelnen zweiten Halbleiterchips zersägt. Anschliessend werden die Halbleiterchips von einem Pick and Place System aufgenommen und unter Anwendung von Druck bei Temperaturen im Bereich von etwa 100 - 150° C auf den ersten Halbleiterchip auflaminiert. Dieser Montageprozess ist in der Fachwelt unter den Bezeichnungen "precoated chip process" oder "film bonding" bekannt. Die Vorteile dieses Verfahrens liegen darin, dass der Klebstofffilm eine gleichmässige Dicke hat, so dass die montierten Halbleiterchips keine Schräglage (tilt) aufweisen. Zudem erstreckt sich die Klebstoffschicht über die ganze Rückseite des zweiten Halbleiterchips, so dass keine Gefahr für Lufteinschlüsse besteht und ohne dass ein Fillet aus Klebstoff den zweiten Halbleiterchip umrundet. Dies erlaubt es, Anschlussflächen (pads) für die Bonddrähte, die die beiden Halbleiterchips verbinden sollen, unmittelbar neben dem Rand des zweiten Halbleiterchips auf dem ersten Halbleiterchip vorzusehen.

Um auch minimalste Verletzungen des Halbleiterchips bei der Montage zu vermeiden, werden Greifwerkzeuge verwendet, deren Saugorgan aus Gummi besteht. Gummi hat zusätzlich den Vorteil, dass es die Hohlkammer gut abdichtet, so dass der Halbleiterchip mit relativ grosser Ansaugkraft von der Folie abgelöst werden kann.

Um Platz zu sparen, werden die Halbleiterchips zunehmend dünner gemacht. Bei einer Dicke von etwa 150 µm kommt es aber vor, dass sich der vom Greifwerkzeug aufgenommenen Halbleiterchip verbiegt, weil der Halbleiterchip unter dem durch das Vakuum bewirkten Druck gegen die Saugöffnung gedrückt wird. Bei einer Dicke von 100 µm ist dies praktisch ausnahmslos so. Beim Plazieren des Halbleiterchips auf dem unteren Halbleiterchip bilden sich unter dem zweiten Halbleiterchip unerwünschte Luftblasen, weil der verbogene Chip zuerst an seinen Kanten zur Auflage auf dem ersten Halbleiterchip kommt und den zwischen den beiden Halbleiterchips gebildeten Hohlraum abdichtet, so dass die eingeschlossene Luft nicht mehr entweichen kann.

Der Erfindung liegt die Aufgabe zugrunde, ein Greifwerkzeug zu entwickeln, das eine problemlose Montage dünner Halbleiterchips ermöglicht.

Die Erfindung besteht in den in den Ansprüchen 1 und 6 angegebenen Merkmalen. Vorteilhafte Ausgestaltungen ergeben sich aus den abhängigen Ansprüchen.

Die Lösung der Aufgabe gelingt mit einem Greifwerkzeug, das ein Saugorgan aus elastisch deformierbarem Material aufweist, dessen den Halbleiterchip aufnehmende Fläche konvex ist. Für die Zuführung des Vakuums weist die den Halbleiterchip aufnehmende Fläche des Saugorgans beispielsweise im Bereich ihrer Kanten angeordnete, mit Vakuum beaufschlagbare Öffnungen auf, während das Zentrum dieser Fläche keine Öffnungen aufweist. Alternativ weist das Saugorgan mindestens eine mit porösem Material gefüllte Kavität auf, über die das Vakuum zu der konvexen Fläche geführt wird. Beim Absetzen des Halbleiterchips auf einem bereits montierten Halbleiterchip wird die konvexe Fläche infolge des sich aufbauenden Druckes zunehmend deformiert, bis sie und der aufgenommene Halbleiterchip flach sind. Der Druck baut sich vom Zentrum des Saugorgans nach aussen auf. Dabei wird der Halbleiterchip auf dem unteren Halbleiterchip abgerollt, wobei die Luft laufend entweichen kann.

Bei diesem Montageverfahren wird also der vom Saugorgan aufgenommene Halbleiterchip vor dem Absetzen auf dem bereits montierten Halbleiterchip in eine konvexe Form gebracht und dann während der letzten Phase des Absetzens in seine normale Form zurückgebracht.

Nachfolgend werden Ausführungsbeispiele der Erfindung anhand der Zeichnung näher erläutert. Die Figuren sind nicht massstabsgetreu dargestellt, sondern so, um das Wesen der Erfindung illustrativ zum Ausdruck zu bringen.

Es zeigen:
- Fig. 1: ein Greifwerkzeug mit einem Saugorgan mit einer konvexen Fläche in seitlichem Querschnitt, das zum Montieren eines Halbleiterchips dient,
- Fig. 2A, B: die konvexe Fläche in Aufsicht,
- Fig. 3: ein zweites Greifwerkzeug in seitlichem Querschnitt,
- Fig. 4A: ein drittes Greifwerkzeug in seitlichem Querschnitt,
- Fig. 4B: die konvexe Fläche des dritten Greifwerkzeugs in Aufsicht, und
- Fig. 5, 6: Momentaufnahmen während des Montageprozesses.

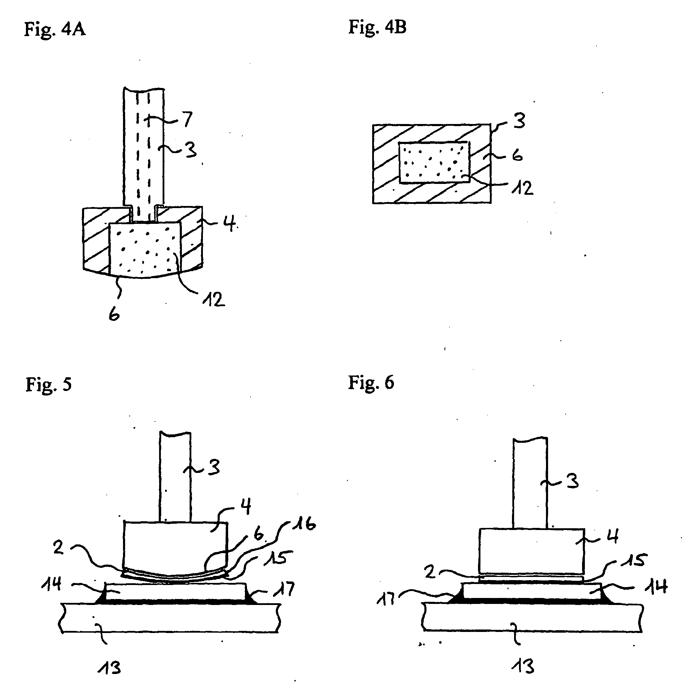

Die Fig. 1 zeigt in seitlichem Querschnitt ein Greifwerkzeug 1, das einen Halbleiterchip 2 aufgenommen hat. Das Greifwerkzeug 1 umfasst einen Schaft 3 und ein am Schaft 3 befestigtes Saugorgan 4 aus elastisch deformierbarem Material wie z.B. Gummi. Am unteren Ende des Schafts 3 ist eine Platte 5 aus einem formstabilen Material befestigt. Schaft 3 und Platte 5 sind in der Regel aus einem Stück gebildet. Die Platte 5 stützt das Saugorgan 4 ab, um den vom Schaft 3 beim Absetzen des Halbleiterchips 2 erzeugten Druck auf das ganze Saugorgan 4 zu übertragen und um zu verhindern, dass sich das Saugorgan 4 gegen oben in Richtung der Platte 5 verbiegen kann. Erfindungsgemäss ist die dem Halbleiterchip 2 zugewandte Fläche 6 des Saugorgans 4 konvex ausgebildet. Das Mass der Konvexität, d.h. der Höhenunterschied zwischen dem Zentrum und dem Rand der konvexen Fläche 6 ist mit dem Bezugszeichen H bezeichnet. Das Saugorgan 4 hält den Halbleiterchip 2 mit Vakuum, das über eine Längsbohrung 7 im Schaft 3 zur konvexen Fläche 6 zugeführt wird. Im folgenden werden zwei Ausführungsbeispiele erläutert, die sich in der Art der Zuführung des Vakuums unterscheiden.

### Beispiel 1

Bei diesem Ausführungsbeispiel weist die dem Halbleiterchip 2 zugewandte konvexe Fläche 6 des Saugorgans 4 mit Vakuum beaufschlagbare Öffnungen 8 auf. Die Öffnungen 8 sind in der Nähe des Randes der Fläche 6 angeordnet, während das Zentrum der Fläche 6 keine Öffnungen aufweist. Die Fig. 2A und Fig. 2B zeigen die Fläche 6 in Aufsicht. Die Öffnungen 8 sind beispielsweise parallel zu den Kanten 9 des Saugorgans 4 verlaufende Schlitze 10, wie in der Fig. 2A gezeigt ist, oder bestehen aus einer Vielzahl im Bereich der Kanten 9 angeordneter Bohrungen 11, wie in der Fig. 2B gezeigt ist.

Die Fig. 2A zeigt auch ein kartesisches Koordinatensystem, dessen Achsen mit x und y bezeichnet sind. Die Fläche 6 ist entweder bezüglich einer einzigen Richtung, beispielsweise der x-Richtung, konvex ausgebildet oder sie ist bezüglich der x- und der y-Richtung konvex ausgebildet.

Die Fig. 3 zeigt ein Ausführungsbeispiel des Greifwerkzeugs 1, bei dem die Vakuumkanäle 18 soweit als möglich im Schaft 3 und innerhalb der Platte 5 verlaufen. Im Saugorgan 4 verlaufen die Vakuumkanäle 18 nur noch in senkrechter Richtung. Auf diese Weise wird die mechanische Stabilität des Zentralbereichs des Saugorgans 4 vergrössert.

### Beispiel 2

Bei diesem, anhand der Fig. 4A und 4B erläuterten Ausführungsbeispiel weist das Saugorgan 4 eine mit porösem Material gefüllte Kavität 12 auf, die mit Vakuum beaufschlagbar ist. Die Kavität 12 befindet sich beispielsweise im Zentrum der Fläche 6 des Saugorgans 4.

Eine weitere Möglichkeit besteht darin, Schlitze 10 und/oder Bohrungen 11 gemäss dem Beispiel 1 vorzusehen und diese mit porösem Material zu füllen.

Die Fig. 5 und 6 zeigen je eine Momentaufnahme des Prozesses des Absetzens des Halbleiterchips 2 auf einem bereits auf einem Substrat 13 montierten Halbleiterchip 14, wobei Details des Greifwerkzeugs 1 nicht dargestellt sind. Auf der Rückseite des Halbleiterchips 2 haftet ein Klebstofffilm 15. Unter dem Halbleiterchip 2 ist im folgenden der Halbleiterchip 2 mitsamt dem auf seiner Rückseite aufgebrachten Klebstofffilm 15 zu verstehen. Der Halbleiterchip 2 hat sich infolge des in den Öffnungen 8 (Fig. 1) herrschenden Vakuums der Wölbung der konvexen Fläche 6 des Saugorgans 4 angepasst. Zuerst trifft somit die Mitte des Halbleiterchips 2 auf dem Halbleiterchip 14 auf. Dieser Zustand ist in der Fig. 5 dargestellt. Wenn der Schaft 3 des Greifwerkzeugs 1 nun weiter abgesenkt wird, baut sich ein Druck auf, der eine zunehmende Verformung des Saugorgans 4 bewirkt, bis der Halbleiterchip 2 plan auf dem Halbleiterchip 14 aufliegt. Dieser Zustand ist in der Fig. 6 dargestellt. Dank der konvexen Form der Fläche 6 baut sich der Druck vom Zentrum des Saugorgans 4 nach aussen auf. Dabei wird der Halbleiterchip 2 auf dem Halbleiterchip 14 abgerollt, wobei die Luft laufend entweichen kann. Erst am Schluss treffen die Kanten 16 des Halbleiterchips 2 auf dem Halbleiterchip 14 auf. Damit der Klebstofffilm 15 seine Haftfähigkeit entwickelt, wird das Substrat 13 in herkömmlicher Weise auf die erforderliche Temperatur aufgeheizt. Während der Halbleiterchip 14 in herkömmlicher Art von einem Fillet 17 aus Klebstoff umgeben ist, fehlt ein solches Fillet beim Halbleiterchip 2.

Das Mass der Konvexität der Fläche 6 des Saugorgans 4 liegt bevorzugt in der Grössenordnung der halben Dicke des Klebstofffilms 15. Bei einer Dicke des Klebstofffilms 15 von 60 µm beträgt der Höhenunterschied H (Fig. 1) zwischen dem Zentrum und dem Rand der Fläche 6 also beispielsweise etwa 30 µm.

Da die Konvexität der Fläche 6 im Vergleich zu ihren Abmessungen von typisch 10 mm * 10 mm relativ gering ist, kann die Platte 5 entfallen, wenn das Saugorgan 4 selbst einerseits die notwendige Steifheit oder Härte und andererseits die notwendige Elastizität aufweist, um die Fläche 6 vom unbelasteten, konvexen Zustand (Fig. 5) in den beim Absetzen des Halbleiterchips 2 erforderlichen flachen Zustand (Fig. 6) zu bringen.

Während der Übergangsphase von dem in der Fig. 5 gezeigten Zustand, wo der Halbleiterchip 2 auf den Halbleiterchip 14 auftrifft, und dem in der Fig. 6 gezeigten Zustand, wo der Halbleiterchip 2 plan auf dem Halbleiterchip 14 aufliegt, kann das Absenken des Greifwerkzeugs 1 beispielsweise mit konstanter Geschwindigkeit oder mit einem dem gewünschten Verlauf des Druck- bzw. Kraftaufbaus angepassten Geschwindigkeitsprofil erfolgen.

## Patentansprüche

1. Greifwerkzeug (1) zum Montieren eines Halbleiterchips (2), mit einem Schaft (3) und mit einem mit Vakuum beaufschlagbaren Saugorgan (4) aus elastisch deformierbarem Material, **dadurch gekennzeichnet, dass** eine den Halbleiterchip (2) aufnehmende Fläche (6) des Saugorgans (4) konvex ausgebildet ist, wobei diese Fläche (6) so ausgebildet ist, dass sie beim Absetzen des Halbleiterchips (2) infolge des sich durch das Absetzen aufbauenden Drucks so weit elastisch deformierbar ist, dass diese Fläche (6) und der aufgenommene Halbleiterchip (2) flach sind.

2. Greifwerkzeug (1) nach Anspruch 1, **dadurch gekennzeichnet, dass** die den Halbleiterchip (2) aufnehmende Fläche (6) des Saugorgans (4) im Bereich ihrer Kanten (9) angeordnete, mit Vakuum beaufschlagbare Öffnungen (8) aufweist, und dass das Zentrum dieser Fläche (6) keine Öffnungen aufweist.

3. Greifwerkzeug (1) nach Anspruch 2, **dadurch gekennzeichnet, dass** die Öffnungen (8) mit porösem Material gefüllt sind.

4. Greifwerkzeug (1) nach Anspruch 1, **dadurch gekennzeichnet, dass** das Saugorgan (4) mindestens eine mit porösem Material gefüllte Kavität (12) aufweist, die mit Vakuum beaufschlagbar ist.

5. Greifwerkzeug (1) nach einem der Ansprüche 1 bis 4, **dadurch gekennzeichnet, dass** am unteren Ende des Schafts (3) eine Platte (5) angeordnet ist, die das Saugorgan (4) abstützt.

6. Verfahren für die Montage eines zweiten Halbleiterchips (2) auf einem ersten Halbleiterchip (14), wobei die Rückseite des zweiten Halbleiterchips (2) mit einem Klebstofffilm (15) beschichtet ist, **dadurch gekennzeichnet, dass** der zweite Halbleiterchip (2) von einem elastisch deformierbaren Saugorgan (4) mit einer konvexen Fläche (6) aufgenommen wird, wobei sich der zweite Halbleiterchip (2) der Wölbung der konvexen Fläche (6) des Saugorgans (4) anpasst, und dass der zweite Halbleiterchip (2) auf dem ersten Halbleiterchip (14) abgesetzt wird, wobei vom Zentrum des Saugorgans (4) aus durch das Absetzen ein Druck aufgebaut wird, der eine zunehmende Verformung des Saugorgans (4) bewirkt, so dass der zweite Halbleiterchip (2) auf dem Halbleiterchip 14 abgerollt wird, bis der zweite Halbleiterchip (2) plan auf dem ersten Halbleiterchip (14) aufliegt.

## Claims

1. Pick-up tool (1) for mounting a semiconductor chip, with a shaft (3) and a suction organ (4) being made of elastically deformable material to which vacuum can be applied, **characterised in that** a surface (6) for picking the semiconductor chip (2) is formed convex wherein this surface (6) is formed such that as a result of the pressure building up during the placement it is deformable so far that this surface (6) and the picked-up semiconductor chip (2) are flat.

2. Pick-up tool according to claim 1, **characterised in that** the surface (6) of the suction organ (4) for picking the semiconductor chip (2) has openings (8) arranged in the area of its edges (9) to which vacuum can be applied, and that the centre of this surface (6) has no openings.

3. Pick-up tool (1) according to claim 2, **characterised in that** the openings (8) are filled with porous material.

4. Pick-up tool (1) according to claim 1, **characterised in that** the suction organ (4) has at least one cavity (12) filled with porous material to which vacuum can be applied.

5. Pick-up tool (1) according to any of claims 1 to 4, **characterised in that** a plate (5) for supporting the suction organ (4) is arranged at the lower end of the shaft (3).

6. Method for mounting a second semiconductor chip (2) onto a first semiconductor chip (14), a back of the second semiconductor chip (2) being coated with an adhesive film (15), **characterised in that** the second semiconductor chip (2) is picked up with a suction organ (4) made of elastically deformable material and having a convex surface (6) whereby the second semiconductor chip (2) adapts itself to the shape of the convex surface (6), and that the second semiconductor chip (2) is placed onto the first semiconductor chip (14), whereby during the placement a pressure builds up evolving from the centre of the suction organ (4) that leads to an increasing deformation of the suction organ (4) so that the second semiconductor chip (2) is rolled on the first semiconductor chip (14) until the second semiconductor chip (2) lies flat on the first semiconductor chip (14).

## Revendications

1. Outil de préhension (1) pour le montage d'une puce à semi-conducteurs (2), comprenant une tige (3) et un organe d'aspiration (4) pouvant être soumis à un vide et constitué d'un matériau élastiquement déformable, **caractérisé en ce qu'**une surface (6) de l'organe d'aspiration (4), laquelle réceptionne la puce à semi-conducteurs (2), est réalisée avec convexité, cette surface (6) étant réalisée de sorte qu'elle est élastiquement déformable lorsque la puce à semi-conducteurs (2) est posée, en raison de la pression qui s'établit sous l'effet de la pose, dans une mesure telle que cette surface (6) et la puce à semi-conducteurs réceptionnée (2) sont plates.

2. Outil de préhension (1) selon la revendication 1, **caractérisé en ce que** la surface (6) de l'organe d'aspiration (4), laquelle réceptionne la puce à semi-conducteurs (2), présente des ouvertures (8) agencées dans la zone de ses arêtes (9) et pouvant être soumises à un vide, et **en ce que** le centre de cette surface (6) ne présente aucune ouverture.

3. Outil de préhension (1) selon la revendication 2, **caractérisé en ce que** les ouvertures (8) sont remplies d'un matériau poreux.

4. Outil de préhension (1) selon la revendication 1, **caractérisé en ce que** l'organe d'aspiration (4) présente au moins une cavité (12) remplie d'un matériau poreux, laquelle peut être soumise à un vide.

5. Outil de préhension (1) selon l'une des revendications 1 à 4, **caractérisé en ce qu'**une plaque (5) est agencée sur l'extrémité inférieure de la tige (3), laquelle soutient l'organe d'aspiration (4).

6. Procédé pour le montage d'une seconde puce à semi-conducteurs (2) sur une première puce à semi-conducteurs (14), la face arrière de la seconde puce à semi-conducteurs (2) étant enduite d'une pellicule de colle (15), **caractérisé en ce que** la seconde puce à semi-conducteurs (2) est réceptionnée par un organe d'aspiration élastiquement déformable (4) présentant une surface convexe (6), la seconde puce à semi-conducteurs (2) s'adaptant à la courbure de la surface convexe (6) de l'organe d'aspiration (4), et **en ce que** la seconde puce à semi-conducteurs (2) est posée sur la première puce à semi-conducteurs (14), une pression étant établie par la pose depuis le centre de l'organe d'aspiration (4), laquelle occasionne une déformation croissante de l'organe d'aspiration (4), de sorte que la seconde puce à semi-conducteurs (2) est déroulée sur la puce à semi-conducteurs (14), jusqu'à ce que la seconde puce à semi-conducteurs (2) soit posée à plat sur la première puce à semi-conducteurs (14).
